# DEMANDE DE BREVET EUROPEEN

(11) **EP 4 451 086 A1**
(43) Date de publication de la demande: **23.10.2024**
(21) Numéro de dépôt: 24169629.3
(22) Date de dépôt: 11.04.2024
(51) Int. Cl.: G05F 1/56

(54) **CIRCUIT INTÉGRÉ COMPRENANT UNE SOURCE DE COURANT D'INTENSITÉ MODULÉE ET PROCÉDÉ DE GÉNÉRATION CORRESPONDANT**

(30) Priorité: 17.04.2023 FR 2303819
(71) Demandeur: STMicroelectronics International N.V., 1228 Plan-les-Ouates, Geneva (CH)
(72) Inventeur: Le Fevre, Philippe, 13090 Aix en Provence (FR); Gamet, Arnaud, 83910 Pourrieres (FR); Dany, Estelle, 84340 Malaucene (FR)
(74) Mandataire: Casalonga

(57) **Abrégé**

Le circuit intégré comprend une source de courant (IGEN) configurée pour générer un courant de commande (tout) d'intensité modulée par un signal d'entrée (Vin). La source de courant comporte un premier étage (100) configuré pour générer de manière autonome une composante constante (Idc) du courant de commande, et un deuxième étage (200) configuré pour générer de manière autonome une composante (Imod) modulée par le signal d'entrée, du courant de commande.

## Description

Des modes de réalisation et de mise en oeuvre concernent les circuits intégrés, en particulier la génération de courant d'intensité modulée par un signal, notamment dans une boucle de contre-réaction d'un système asservi.

Un système asservi est typiquement prévu pour générer un signal de sortie faisant une contre-réaction (on parle aussi de « rétroaction ») sur sa génération, par le biais d'une boucle de contre-réaction.

La boucle de rétroaction peut générer un signal de rétroaction de nature différente que le signal de sortie. Par exemple, le signal de sortie asservit par la boucle de rétroaction peut être la valeur moyenne de l'amplitude d'un signal oscillateur en tension, ou le niveau de tension d'un point de potentiel ; tandis que le signal de rétroaction peut par exemple être véhiculé par un courant de commande.

Par ailleurs, une grandeur qui n'est pas généré par le système peut asservir le système, par exemple une mesure de la température peut asservir un système générant un signal de sortie de nature quelconque. Le courant de commande peut être généré en fonction de la température afin de commander l'asservissement du signal de sortie.

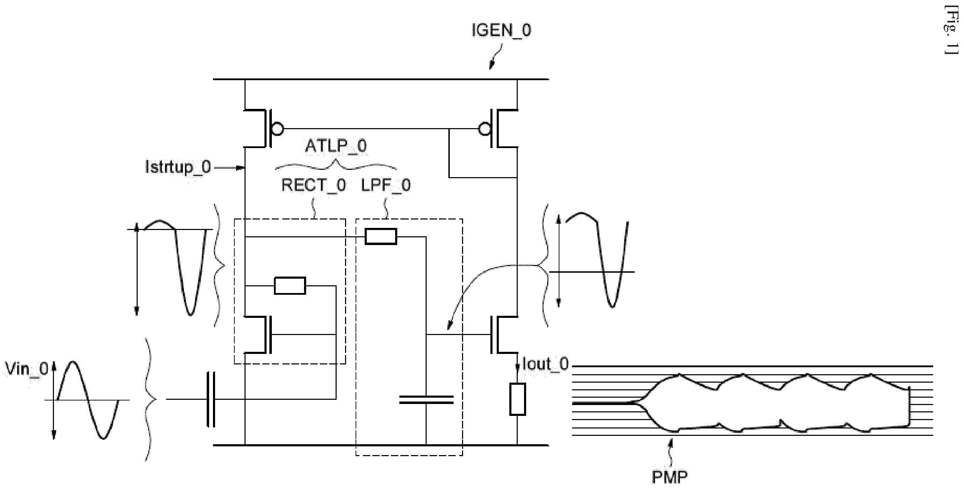

Indépendamment du système asservi, la génération des courants de commande, notamment dans les boucles de contre-réaction, présente des difficultés dans la mesure où les circuits générateurs de courants sont typiquement basés sur une architecture du type multiplicateur-β (« multiplicateur-beta »), tel qu'illustré par exemple par la figure 1.

La figure 1 illustre un exemple classique de circuit générateur de courant IGEN_0 du type multiplicateur-β auto-régulé avec une boucle d'atténuation ATLP_0, typiquement utilisé pour la contre-réaction d'un système générant un signal alternatif Vin_0.

La contre-réaction utilise une non-linéarité de la conception fournissant un effet d'écrêteur RECT_0 et un filtre passe-bas LPF_0 afin de générer un courant de sortie Iout_0 dont l'intensité varie inversement à la valeur moyenne de l'amplitude du signal d'entrée Vin (par l'effet écrêteur RECT_0 pour isoler l'amplitude et par l'effet du filtre LPF_0 pour obtenir une moyenne).

Ce type de circuit IGEN_0 a pour inconvénients de présenter un gain de contre-réaction fortement lié à la valeur de la composante de continue du courant de sortie Iout_0, et qu'il est difficile, voire impossible, de régler un élément du circuit IGEN_0 sans perturber tous les autres. Ainsi, toute modification entraîne un redimensionnement complet du circuit IGEN_0, ce qui rend le circuit difficile à paramétrer et à adapter par exemple en fonction de l'application qui en est faite.

Ce type de circuit IGEN_0 nécessite en outre un courant initial au démarrage Istrtup_0 généré par un circuit annexe, ce qui est désavantageux en soi.

Ce type de circuit peut par ailleurs subir un effet « hump » correspondant sommairement à un effet de transistor parasite dans certaines conditions. L'effet « hump » peut engendrer une amplification de la rétroaction négative sur le signal de sortie Iout_0, réduisant le signal de sortie sous une valeur minimal de fonctionnement et engendrant des redémarrages du circuit avec le courant initial de démarrage Istrtup_0, suivant une allure cyclique de pompage PMP. A toute fin utile au sujet de l'effet « hump », l'homme de l'art pourra se référer par exemple à la publication : Y. Joly et al., « Impact of hump effect on MOSFET mismatch in the sub-threshold area for low power analog applications, » 2010 10th IEEE International Conférence on Solid-State and Integrated Circuit Technology, 2010, pp. 1817-1819, doi: 10.1109/ICSICT.2010.5667684.

Ainsi, il existe un besoin de proposer des sources de courant d'intensité modulée par un signal d'entrée, notamment au sein d'une boucle de contre-réaction d'un système asservi, ne subissant pas les inconvénients susmentionnés.

A cet égard, selon un aspect il est proposé un circuit intégré comprenant une source de courant configurée pour générer un courant de commande d'intensité modulée par un signal d'entrée, dans lequel la source de courant comporte un premier étage configuré pour générer de manière autonome une composante constante du courant de commande, et un deuxième étage configuré pour générer de manière autonome une composante modulée par le signal d'entrée, du courant de commande.

Ainsi, contrairement aux architectures classiques du type multiplicateur-β auto-régulé avec une boucle d'atténuation (figure 1), la génération du courant constant et la génération du courant modulé de rétroaction sont totalement décorrélées. Les deux composantes du courant de commande peuvent ainsi être réglées et paramétrées facilement et avec une grande souplesse, permettant avantageusement d'accélérer la durée des cycles de conception, d'adapter facilement le circuit à une modification ou une mise à jour de circuits annexes collaborant avec la source de courant, et de faciliter les phases de réglage (usuellement « trimming » en anglais) des productions industrielles.

Ainsi, par exemple et en particulier, la composante continue du courant de commande peut être dimensionnée pour annuler ou prévenir l'effet « hump » ou l'effet de pompage cyclique, indépendamment de la conception de la rétroaction. Réciproquement, la composante modulée peut elle aussi être réglée indépendamment de la composante continue. On notera que l'effet « hump » peut se produire ou non de manière aléatoire sur des réalisations données du même circuit intégré.

Selon un mode de réalisation, la source de courant comporte un circuit générateur de référence configuré pour générer un courant de référence, le premier étage comporte un premier montage miroir de courant alimenté par le courant de référence, et le deuxième étage comportant un deuxième montage miroir de courant alimenté par le courant de référence.

Cela correspond à une réalisation simple et efficace, bénéficiant de tous les avantages mentionnés ci-avant. Par exemple le circuit génération de référence peut être un circuit du type référence auto-polarisée (usuellement « self-biased référence » en anglais).

Selon un mode de réalisation, le deuxième étage comporte un circuit convertisseur configuré pour générer un courant de modulation ayant une intensité variant en fonction du signal d'entrée, et pour injecter ou extraire le courant de modulation au courant de référence alimentant le deuxième montage miroir de courant.

Cela permet là-encore d'adapter aisément la fonction de modulation de la composante modulée du principe de génération du courant de commande. En effet, on pourra adapter le circuit convertisseur à une fonction souhaitée pour la modulation, par exemple une fonction linéaire, ou un échelon carré, ou une fonction parabolique, ou toute autre transformation mathématique.

Selon un mode de réalisation, le deuxième étage est configuré pour générer la composante modulée proportionnelle à la valeur moyenne de l'amplitude d'un signal alternatif comme signal d'entrée.

Selon un mode de réalisation, le circuit intégré comporte un système asservi par une boucle de commande, par exemple une boucle de contre-réaction, la boucle de commande comprenant ladite source de courant, le courant de commande asservissant un signal de sortie du système.

Selon un mode de réalisation, le système comporte un oscillateur à quartz configuré pour générer un signal de sortie alternatif du système, le signal de sortie du système étant le signal d'entrée alternatif de la boucle de commande.

Selon un autre aspect, il est proposé un procédé de génération d'un courant de commande d'intensité modulée par un signal d'entrée, dans lequel la génération du courant de commande comporte une première génération autonome d'une composante constante du courant de commande, et une deuxième génération autonome d'une composante modulée par le signal d'entrée, du courant de commande.

Selon un mode de mise en oeuvre, la génération du courant de commande comporte une génération d'un courant de référence alimentant ladite première génération autonome et ladite deuxième génération autonome.

Selon un mode de mise en oeuvre, la deuxième génération autonome de la composante modulée du courant de commande comporte une génération d'un courant de modulation ayant une intensité variant en fonction du signal d'entrée, et une injection ou une extraction du courant de modulation au courant de référence alimentant ladite deuxième génération.

Selon un mode de mise en oeuvre, la composante modulée est proportionnelle à la valeur moyenne de l'amplitude d'un signal d'entrée alternatif.

Selon un mode de mise en oeuvre, le procédé comporte un asservissement d'un système par une boucle de commande, la boucle de commande comprenant ladite génération du courant de commande, le courant de commande asservissant un signal de sortie du système.

Selon un mode de mise en oeuvre, le signal de sortie alternatif du système est généré par un oscillateur à quartz, le signal de sortie du système étant le signal d'entrée alternatif de la boucle de commande.

D'autres avantages et caractéristiques de l'invention apparaîtront à l'examen de la description détaillée de modes de réalisation et de mise en oeuvre, nullement limitatifs, et des dessins annexés, sur lesquels les figures :
[Fig.1], précédemment décrite, illustre un exemple classique de circuit générateur de courant ;
[Fig.2] et
[Fig.3] et
[Fig.4] illustrent des modes de réalisation et de mise en oeuvre de l'invention.

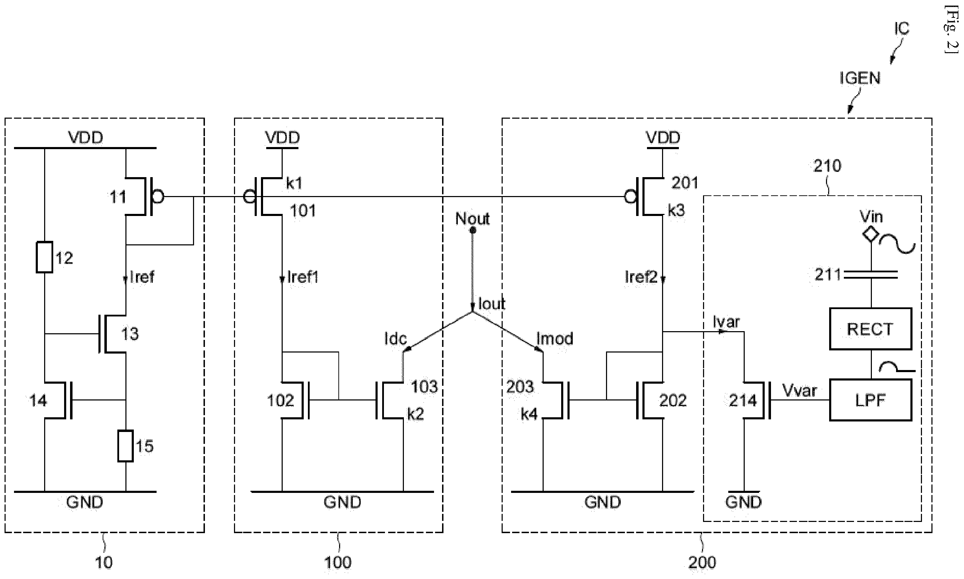

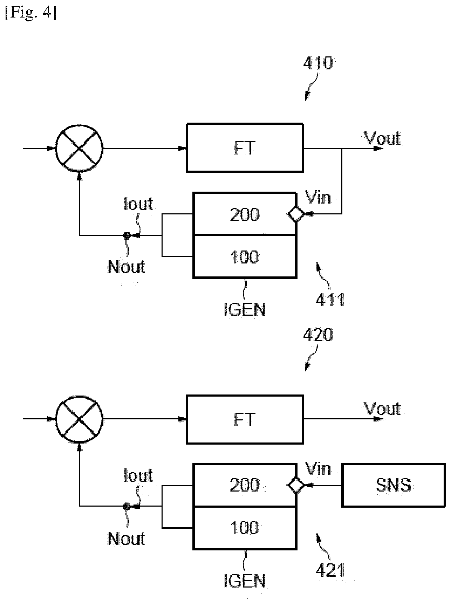

La figure 2 illustre un exemple de circuit d'une source de courant IGEN, usuellement réalisé de façon intégrée dans un circuit intégré IC. Par exemple, la source de courant peut être destinée à appartenir une boucle de commande ou de rétroaction d'un système asservi (voir figure 4 ci-après), afin de générer un courant de commande Iout asservissant un signal de sortie du système Vout.

La source de courant IGEN est configurée pour générer un courant de commande Iout d'intensité modulée par un signal d'entrée Vin.

Le signal d'entrée Vin est par exemple obtenue à partir du signal de sortie Vout.

La source de courant IGEN comporte un premier étage 100 configuré pour générer de manière autonome une composante constante Idc du courant de commande Iout, et un deuxième étage 200 configuré pour générer de manière autonome une composante modulée Imod du courant de commande Iout. La composante modulée Imod est modulée par le signal d'entrée Vin, autrement dit, la composante modulée Imod est générée en fonction du signal d'entrée Vin.

Dans cet exemple, la source de courant IGEN comporte un circuit générateur de référence 10 configuré pour générer un courant de référence Iref constant, par exemple un circuit du type référence auto-polarisée (usuellement « self-biased référence » en anglais). Le premier étage 100 comporte un premier montage miroir de courant 102, 103 alimenté par le courant de référence, ou par une première copie Iref1 du courant de référence Iref. Le deuxième étage 200 comporte un deuxième montage miroir de courant 202, 203 alimenté par le courant de référence, ou par une deuxième copie Iref2 du courant de référence Iref.

En outre, dans cet exemple, pour générer la composante modulée Imod en fonction du signal d'entrée Vin, le deuxième étage 200 comporte un circuit convertisseur 210 configuré pour générer un courant de modulation Ivar ayant une intensité variant en fonction du signal d'entrée Vin. Le courant de modulation Ivar est injecté ou extrait au courant de référence Iref2 alimentant le deuxième montage miroir de courant.

Selon un exemple pratique élémentaire, tel que représenté par la figure 2, le circuit génération de référence 10 du type référence auto-polarisée comporte un transistor PMOS monté en diode 11 dont la source est couplé à une borne de tension d'alimentation VDD, un élément résistif 12 couplé à la borne VDD, un transistor NMOS 13 dont le drain est couplé à cathode (noeud drain-grille) du transistor PMOS monté en diode 11, et dont la grille est couplée à l'élément résistif 12 et au drain d'un autre transistor NMOS 14. La grille de cet autre transistor 14 est couplée à la source du transistor NMOS 13, et sa source est couplée à une borne de tension de référence de masse GND. Une charge 15 est couplé entre la source du transistor NMOS 13 et la masse GND.

Ainsi, le courant de référence Iref généré sur le drain du transistor PMOS monté en diode 11 est constant et en particulier ne varie pas selon des fluctuations de la tension d'alimentation VDD.

Le premier étage 100 comporte un premier transistor PMOS de copie 101 dont la grille est commandée par la tension de la cathode (noeud grille-drain) du transistor PMOS monté en diode 11 (soit la tension de seuil), de manière à générer une première copie Iref1 du courant de référence Iref, que l'on nommera premier courant de copie Iref1. L'intensité du premier courant de copie Iref1 peut être égale à un facteur k1 du courant de référence Iref ou égale au courant de référence Iref (k1=1).

Dans le premier étage 100, le premier montage miroir de courant comporte un transistor NMOS monté en diode 102, couplé entre le drain du premier transistor PMOS de copie 101 et la masse GND, et un transistor NMOS de copie 103 commandée par la tension de la cathode (noeud grille-drain) du transistor NMOS monté en diode 102 (soit la tension de seuil), et dont le drain est couplé à un noeud de sortie Nout et la source à la masse GND.

Ainsi, le premier montage miroir de courant 102, 103 est alimenté par le premier courant de copie Iref1 et permet de générer un premier courant de sortie Idc sur le noeud de sortie Nout. L'intensité du premier courant de sortie Idc peut être égal à un facteur k2 du premier courant de copie Iref1 ou égal au premier courant de copie Iref (k2=1). Ainsi, on a généré un courant constant Idc proportionnel ou égal au courant de référence Iref, qui appartient au courant de commande Iout en tant que composante constante Idc.

Le deuxième étage 200 comporte un deuxième transistor PMOS de copie 201 dont la grille est commandée par la tension de cathode (noeud grille-drain) du transistor PMOS monté en diode 11 (soit la tension de seuil), de manière à générer une deuxième copie Iref2 du courant de référence Iref, que l'on nommera deuxième courant de copie Iref2. L'intensité du deuxième courant de copie Iref2 peut être égale à un facteur k3 du courant de référence Iref ou égale au courant de référence Iref (k3=1).

Dans le deuxième étage 200, le deuxième montage miroir de courant comporte un transistor NMOS monté en diode 202, couplé entre le drain du deuxième transistor PMOS de copie 201 et la masse GND, et un transistor NMOS de copie 203 commandée par la tension de cathode (noeud grille-drain) du transistor NMOS monté en diode 202 (soit tension de seuil), et dont le drain est couplé au noeud de sortie Nout et la source à la masse GND.

Ainsi, le deuxième montage miroir de courant 202, 203 est alimenté par le deuxième courant de copie Iref2 et permet de générer un deuxième courant de sortie Imod sur le noeud de sortie Nout. L'intensité du deuxième courant de sortie Imod peut être égal à un facteur k4 du courant qui circule dans le transistor NMOS monté en diode 202 du deuxième étage 200.

Or, le courant de modulation Ivar a été injecté ou extrait (selon le signe de la génération par le convertisseur d'entrée 210 du courant de modulation Ivar) au deuxième courant de copie Iref2 alimentant le deuxième montage miroir de courant 202, 203, c'est-à-dire au courant qui circule dans le transistor NMOS monté en diode 202 du deuxième étage 200.

Ainsi, on a généré un courant Imod supportant des variations générées en fonction du signal d'entrée Vin, et qui appartient au courant de commande Iout en tant que composante modulée Imod.

On pourra préférer une extraction du courant de modulation Ivar de même signe (positif ou négatif) que le signe deuxième courant de copie Iref2 (ou une injection du courant de modulation Ivar de signe opposé au signe deuxième courant de copie Iref2). En d'autres termes, on pourra préférer que le courant qui résulte de l'extraction/injection soit inférieure en valeur absolue au deuxième courant de copie Iref2, soit : |Iref2-Ivar| ≤ |Iref2|. Cela permet que la composante modulée Imod n'incorpore pas sa propre composante constante.

Par exemple, un transistor NMOS de modulation 214 couplé entre la masse GND et l'anode (noeud drain-gille) du transistor 202, et commandé par un signal de commande de modulation Vvar, peut permettre une telle extraction du courant Ivar de signe positif au deuxième courant de copie Iref2 de signe positif.

Enfin, dans cet exemple, le convertisseur d'entrée 210 est adapté pour générer le courant de modulation Ivar correspondant à la valeur moyenne de l'amplitude du signal d'entrée alternatif Vin ; de sorte que, la composante modulée Imod est inversement proportionnel à ladite valeur moyenne de l'amplitude du signal d'entrée alternatif Vin (notamment selon l'intensité du courant de modulation Ivar et les facteurs k3, k4).

A cet égard, le convertisseur d'entrée 210 peut comporter un circuit redresseur ou écrêteur RECT recevant le signal d'entrée Vin, typiquement via un élément capacitif 211 retirant un décalage, suivi d'un circuit de filtre passe-bas LPF fournissant le signal de commande de modulation Vvar.

Ainsi, le courant de commande Iout sur le noeud de sortie Nout résulte de la somme des courants circulant sur le noeud de sortie, c'est-à-dire la somme de la composante continue Idc générée par le premier étage 100 et de la composante modulée Imod générée par le deuxième étage 200.

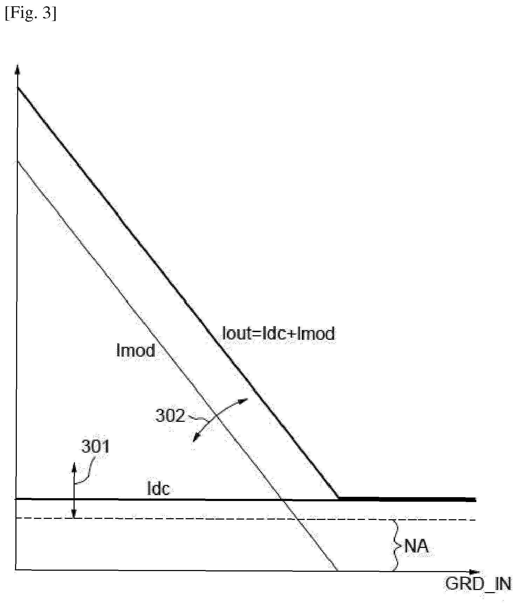

On se réfère à cet égard à la figure 3.

La figure 3 illustre, sous la forme d'un graphique, le procédé de génération du courant de commande Iout = Idc + Imod dont l'intensité est modulée par le signal d'entrée Vin (figure 2), comportant une première génération autonome de la composante constante Idc0 du courant de commande Iout, et une deuxième génération autonome de la composante modulée Imod du courant de commande, la composante modulée Imod étant modulée par le signal d'entrée.

Le courant de commande Iout est par exemple obtenu par la somme de la composante continue Idc et de la composante modulée Imod circulant sur le noeud de sortie Nout (figure 2).

Etant donné que la première génération par le premier étage 100 et la deuxième génération par le deuxième étage 200 génèrent respectivement, de manière autonome et indépendante, la composante constante Idc0 et la composante modulée Imod, les deux composantes Idc, Imod du courant de commande Iout peuvent être réglées et paramétrées 301, 302 facilement et avec une grande souplesse.

Dans le cas de la figure 3, et la composante modulée est proportionnelle à une grandeur d'entrée GRD_IN, et le réglage 302 peut par exemple correspondre au coefficient de la proportionnalité, c'est-à-dire l'inclinaison de la pente.

La composante continue Idc peut par exemple être réglée 301 à un niveau supérieur à une limite NA, de sorte que le signal de commande Iout reste toujours supérieure à cette valeur limite NA.

Le courant constant Idc peut ainsi être dimensionné 301 pour éviter des points de polarisation spécifiques NA, par exemple afin d'éviter de couper la polarisation de l'ensemble du circuit et d'éviter un comportement non-linéaire indésirable du circuit (une cause possible d'un effet de pompage cyclique). Le courant constant Idc peut également être prévu pour éviter certaines zones de polarisation spécifiques telles que des zones de polarisation pouvant engendrer un effet de bosse ou effet « hump ».

Par ailleurs, on pourra aussi adapter le circuit convertisseur 210 à une fonction souhaitée pour la modulation, par exemple une fonction linéaire telle que représentée Imod, ou un échelon carré, ou une fonction parabolique, ou toute autre transformation mathématique.

L'architecture décrite en relation avec la figure 2 permet également de revenir à un point de polarisation de départ lorsque tous les stimuli sont désactivés, sans recourir à une génération d'un signal de réinitialisation.

La figure 4 illustre deux exemples de systèmes asservis 410, 420 par une boucle de commande 411, 421, et comportant des moyens FT prévus pour générer un signal de sortie Vout.

Par exemple, chaque système asservi 410, 420 peut être réalisé de façon intégrée dans le circuit intégré CI décrit précédemment en relation avec la figure 2. La boucle de commande comprend la source de courant IGEN telle que décrite précédemment en relation avec les figures 2 et 3, de sorte que le courant de commande Iout permet d'asservir la génération du signal de sortie Vout du système.

Dans le premier exemple de système asservi 410, la boucle de commande 411 est du type « boucle fermée de contre-réaction » (ou « feedback loop » en anglais) et utilise la sortie du système Vout pour réguler sa propre génération.

Dans ce cas, le système 410 peut par exemple comporter un oscillateur à quartz FT configuré pour générer un signal de sortie du système Vout du type signal d'horloge alternatif. Le signal de sortie alternatif du système Vout est ainsi utilisé en tant que signal d'entrée alternatif Vin de la boucle de commande 411, et donc de la source de courant IGEN telle que décrite précédemment en relation avec la figure 2.

Dans le deuxième exemple de système asservi 420, la boucle de commande 421 est du type « boucle ouverte de paramétrage » et permet de réguler la sortie du système Vout en fonction d'un paramètre extérieur, tel qu'une mesure faite par un capteur SNS.

En effet, le critère de modulation dans l'application d'un oscillateur à quartz est typiquement l'amplitude de l'oscillation, tandis que d'autres applications peuvent être basée sur d'autres critères de modulation tels que la température, la tension d'alimentation, ou autre. La décorrélation des deux étages 100, 200 du générateur de courant IGEN permet d'adapter librement et facilement la fonctionnalité de rétroaction de manière à supprimer d'éventuelles instabilités de la conception (par exemple un effet de pompage).

Enfin, l'invention n'est pas limité aux modes de réalisation et de mise en oeuvre décrits ci-avant mais en embrasse toutes les variantes, par exemple, comme mentionné précédemment, les signes des courants et/ou des tensions de polarisation peuvent être inversés, la fonction de la modulation peut être définie différemment, et d'autres type de circuit peuvent être envisagés notamment pour le circuit générateur de référence.

## Revendications

1. Circuit intégré comprenant une source de courant (IGEN) configurée pour générer un courant de commande (tout) d'intensité modulée par un signal d'entrée (Vin), dans lequel la source de courant comporte un premier étage (100) configuré pour générer de manière autonome une composante constante (Idc) du courant de commande, et un deuxième étage (200) configuré pour générer de manière autonome une composante (Imod) modulée par le signal d'entrée, du courant de commande.

2. Circuit intégré selon la revendication 1, dans lequel la source de courant (IGEN) comporte un circuit générateur de référence (10) configuré pour générer un courant de référence (Iref), le premier étage (100) comporte un premier montage miroir de courant (102, 103) alimenté par le courant de référence (Iref1), et le deuxième étage (200) comporte un deuxième montage miroir de courant (202, 203) alimenté par le courant de référence (Iref2).

3. Circuit intégré selon la revendication 2, dans lequel le deuxième étage (200) comporte un circuit convertisseur (210) configuré pour générer un courant de modulation (Ivar) ayant une intensité variant en fonction du signal d'entrée (Vin), et pour injecter ou extraire le courant de modulation (Ivar) au courant de référence (Iref2) alimentant le deuxième montage miroir de courant.

4. Circuit intégré selon l'une des revendications 1 à 3, dans lequel le deuxième étage (200) est configuré pour générer la composante modulée (Imod) proportionnelle à la valeur moyenne de l'amplitude d'un signal alternatif comme signal d'entrée (Vin).

5. Circuit intégré selon l'une des revendications précédentes, comportant un système asservi (410, 420) par une boucle de commande (411, 421), la boucle de commande comprenant ladite source de courant (IGEN), le courant de commande (Iout) asservissant un signal de sortie du système (Vout).

6. Circuit intégré selon la revendication 5, dans lequel le système (410) comporte un oscillateur à quartz (FT) configuré pour générer un signal de sortie alternatif du système (Vout), le signal de sortie alternatif du système (Vout) étant le signal d'entrée alternatif (Vin) de la boucle de commande (411).

7. Procédé de génération d'un courant de commande (tout) d'intensité modulée par un signal d'entrée (Vin), dans lequel la génération du courant de commande comporte une première génération (100) autonome d'une composante constante (Idc) du courant de commande, et une deuxième génération (200) autonome d'une composante (Imod) modulée par le signal d'entrée (Vin), du courant de commande.

8. Procédé selon la revendication 7, dans lequel la génération du courant de commande (Iout) comporte une génération d'un courant de référence (Iref) alimentant ladite première génération autonome (100) et ladite deuxième génération autonome (200).

9. Procédé selon la revendication 8, dans lequel la deuxième génération autonome (200) de la composante modulée (Imod) du courant de commande comporte une génération d'un courant de modulation (Ivar) ayant une intensité variant en fonction du signal d'entrée (Vin), et une injection ou une extraction du courant de modulation (Ivar) au courant de référence (Iref2) alimentant ladite deuxième génération.

10. Procédé selon l'une des revendications 7 à 9, dans lequel la composante modulée (Imod) est proportionnelle à la valeur moyenne de l'amplitude d'un signal d'entrée alternatif (Vout).

11. Procédé selon l'une des revendications 7 à 10, comportant un asservissement d'un système (410, 420) par une boucle de commande (411, 421), la boucle de commande comprenant ladite génération du courant de commande (Iout), le courant de commande (Iout) asservissant un signal de sortie (Vout) du système.

12. Procédé selon la revendication 11, dans lequel le signal de sortie alternatif du système (Vout) est généré par un oscillateur à quartz, le signal de sortie alternatif du système (Vout) étant le signal d'entrée alternatif (Vin) de la boucle de commande (411).
